# EUROPEAN PATENT APPLICATION

(11) **EP 2 565 003 A1**
(43) Date of publication of application: **06.03.2013**
(21) Application number: 12182389.2
(22) Date of filing: 30.08.2012
(51) Int. Cl.: B28B 19/00, E04C 2/04, E04F 13/09, G06F 17/50, E04F 13/08

(54) **A method for creating a brick appearance to a support structure and a panel therefor**

(30) Priority: 30.08.2011 BE 201100517
(71) Applicant: Aldinvest NV, 9700 Oudenaarde (BE)
(72) Inventor: Ceulemans, Bart, 9700 Oudenaarde (BE); Vande Moortel, Peter, 9700 Oudenaarde (BE)
(74) Representative: Brants, Johan P.E.

(57) **Abstract**

The present invention provides a working method for mounting a brick facade onto a supporting base. This invention also provides a working method for the production of flat panels and corner panels, suitable to be used in the working method for adding a brick facade onto a supporting structure. This invention also relates to flat panels and corner panels which can be realized using the working method according to the present invention.

## Description

### Technical Aspects

This invention relates to a method for the construction of facades onto a supporting structure. More particularly, the invention relates to an efficient and ergonomic method for covering the supporting structure with square panels equipped with brick lining or brick strips, together with their corresponding joints. This invention also relates to a rectangular panel partially provided with bricks or brick strips and joints along the lateral edges.

### State of the art

Construction panels provided with bricks or brick strips and their corresponding joints are known, e.g. from EP 0183 652, GB 2457 293 and US 3 426 490.

EP 0 183 652 describes a fully prefabricated facade as a wall consisting of one part, with a reinforced concrete beam at the top, a second reinforced concrete beam at the bottom and masonry consisting of numerous bricks and joints filled with mortar between these bricks.

GB 2457 293 describes overlapping plates with a toothed profile on at least one of the lateral edges. These protruding teeth are very vulnerable, especially during transport, and therefore economically and structurally disadvantageous.

US 3 426 490 relates to providing concrete bricks onto a plate by means of a mould. This industrial prefab construction method offers no variation and only limitedly depends on the number of moulds used.

Other methods for producing panels provided with bricks are also known, e.g. from GB 2 455 284. This patent describes a method for the production of prefabricated blocks provided with a selected pattern of facade elements, such as, for instance, half stones which are moulded onto a frontal section in one plane.

The existing systems involving the use of moulds have several disadvantages, such as a limited choice of concrete bricks and brick shapes, and a limited choice for brickwork bond. Another major disadvantage is the size of the prefabricated panels. Their dimension does not always allow installation at the construction site by one single person without the intervention of lifting equipment or crane vehicles. The state of the art is based on standard panels or facades.

The aim of the present invention is to at least partially eliminating these aforesaid disadvantages and more in particular to propose a suitable solution for ceramic stones, which are often preferred because of their aesthetic advantages but also because of constructional reasons.

### Summary

For this purpose, the invention provides a method for providing ceramic bricks and preferably facade bricks onto a supporting structure as described in claim 1. Preferred embodiments are described in claims 2-4.

In a second aspect, this invention provides a method for the production of flat straight panels or straight corner panels, as described in claim 5.

In a third aspect, this invention provides a flat panel, as described in claim 9, of which the preferred embodiments are described in claims 10-13.

In a fourth aspect, as described in claim 14, the present invention also provides a construction kit.

### Description of the figures

**Figure 1** shows a schematic top view of a corner brick as used in the present invention.
**Figure 2** shows a schematic three-dimensional view of two corner bricks placed underneath each other, in a preferred embodiment of the corner panel according to the present invention.
**Figure 3** illustrates the stone pattern in two preferred embodiments according to the present invention for the flat panels A and B, with an indication of the corresponding free spaces on the sides.
**Figure 4** shows the configuration of two adjacent panels A and B, with indication of the overlapping bricks which were applied after the anchoring of the substrate panels to a supporting structure.
**Figure 5** shows the configuration of two adjacent embodiments of panels A' and B', with the bricks positioned in a wild bond.
**Figure 6** shows an embodiment of the brick plan of a wall with facade openings.
**Figure 7** **and** **8** show a preferred embodiment of a panel plan for the facade shown in Figure 6, with indication of the flat panels (figure 8) and the corner panels.
**Figure 9** shows the preferred embodiment of a panel plan for the facade shown in Figure 6, with indication of the corner panels.
**Figure 10** shows a detail of a plan for an angle joint.
**Figure 11** shows an embodiment of the faces E and F of a corner panel, in order to cover the angle joint shown in Figure 10.
**Figure 12** shows a preferred embodiment of a brick facade, built according to the method proposed by the present invention.
**Figure 13** shows the detail of an embodiment for contiguous free spaces of two flat panels M and N.
**Figures 14-16** show different embodiments of flat panels with different brickwork bonds.

### Detailed Description

In a first aspect, this invention relates to a method for providing a brick façade onto a supporting structure starting from an individual brick plan, for an individual building plan. The brick plan is subdivided into panels. These panels consist of straight and flat substrate panels on which the ceramic bricks are sequentially glued, after which the joints are applied. The sides of the substrate panels are only partially provided with bricks, which means that some spaces are left free. Preferred embodiments of joints are: the glue joint: with a thickness of 2 to 4 mm, the thin joint: with a thickness of 5 to 8 mm, or the classical joint with a thickness of 10 to 12 mm

The lateral sides of substrate panels are not only equipped with bricks, but also with free spaces.. In general the free space is the last space in a row of bricks, in which there is insufficient space for a full brick. On the substrate panels, only full-size bricks are provided, no partial bricks.

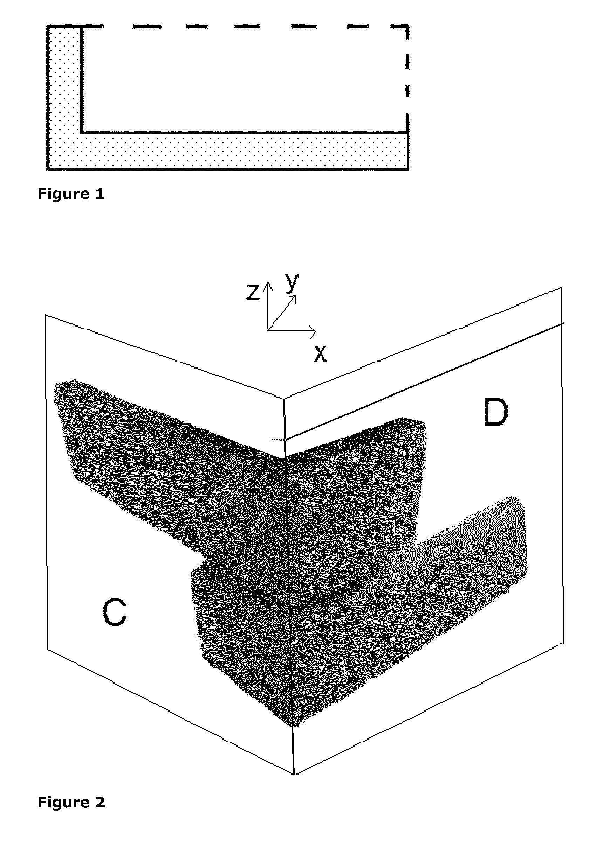

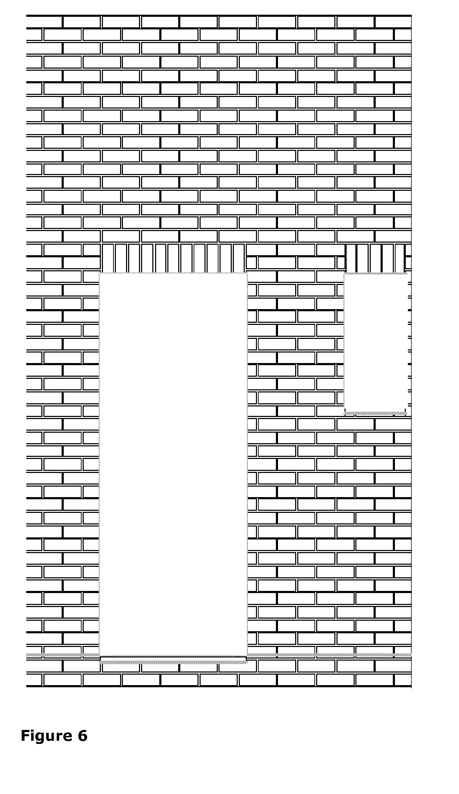

Figure 6 shows an embodiment for a brick plan according to this invention. The term "bricks" relates to the ceramic products used. These ceramic products may either be bricks, corner bricks, corner brick strips, tiles or earthenware, stones or stone strips. The preferred materiel consists of facade bricks made of baked clay with a thickness of 2 to 4 cm. The term "corner stone" refers to a brick that is provided on an corner of the construction. A "cornerbrick strip" is a brick strip suitable for covering an angle or corner. Such corner brick strip can be obtained by cutting a beam-shaped piece out of a full-size brick, so that an L-shaped brick strip is obtained in top view (Figure 1 and 2). The dotted line in Figure 1 indicates the circumference of a full-sized brick, while the hatched area represents the corner brick itself.

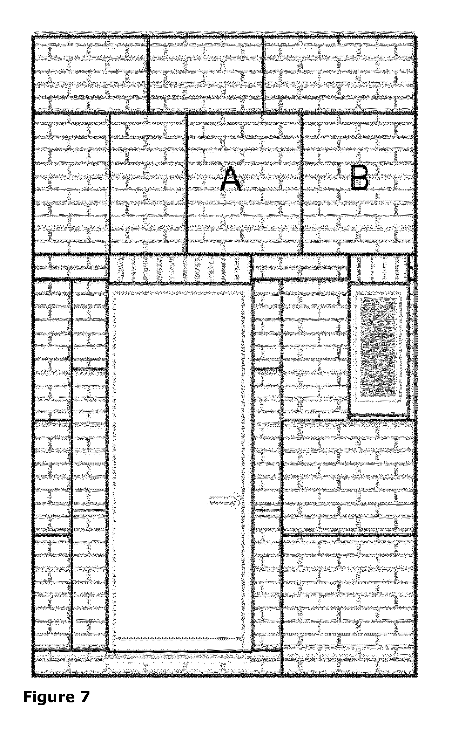

The panel plan includes both flat rectangular or square panels, as well as corner panels which latter are composed of two flat rectangular or square panels combined at a right angle (in general). Figure 7 shows an embodiment of a panel plan according to the present invention.

The term "bricks" may also relate to a "brick strip", i.e. thinner bricks than usual.

The term "flat panel" relates to a polygonal and preferably quadrangular panel in one plane, having straight and parallel edges. The term "corner panel" refers to a panel consisting of two segments having a shared edge and which are joined at an angle. The angle between both segments varies between 85° and 95° and is preferably equal to 90°.

The term "supporting structure" relates to a structure capable of supporting a brick or stone surface. Examples of a supporting structure may be a wall, an outer wall of a building shell, a timber frame, a facade, a floor, or a roof.

The term "substrate panel" as used in the present invention relates to a supporting material suitable for supporting the bricks or brick strips and also suitable for providing onto a supporting structure by means of anchoring devices. The substrate panel can be made of e.g. wood, plate material, laminate, nets or floor nets. Preferably, the substrate panel is manufactured using a material as described in EP 2 060 389 on the basis of magnesium, because of its excellent adhesive properties. The preferred materials are magnesium, magnesium oxide and magnesium chloride, because of their excellent resistance coefficient and good thermal conductivity coefficient.

In a preferred embodiment, the substrate panel is by the brand name Megapan ®. Such a material preferably has a density of approximately 1000 kg/m2 (according to EN12467), preferable a bending strength of Mpa > 16 (according to EN 12467), preferably a Young's modulus Mpa> 5 (in accordance with EN124677, preferably an impact resistance KJ/m³ > 3,6, preferably water absorption 18%,preferably a hygric movement 2.5 mm / m (30-90% EN1604), preferably a thickness swelling of 0,5 '% at saturation, preferably a heat shrink 0,26%, preferably a thermal resistance coefficient 1,3 W / m² K (according to EN12664),and preferably a thermal conductivity coefficient 0.216 W / (mk) (according to EN12664). The term approximately is to be understood + or - 10% of the absolute value.

The term "anchoring device" relates to a device which is suitable for anchoringa substrate panel, a flat panel or a corner panel onto a supporting structure. Some examples of anchoring devices are: nails, screws or staples.

The term "adhesive agent" relates to a substance suitable for gluing bricks, brick strips, corner bricks and corner brick strips onto the substrate panel and to one another. The preferred adhesive agent is glue, and more particularly silicon glue, especially MS polymer glue. The term "MS polymer glue" refers to Modified Silyl Polymer Glue, which is a glue consisting of modified silane (SiH4) molecules. The adhesive bonding is achieved through the interaction with water, for example moisture in the air, which reacts and polymerizes with the silane compounds. In anotherembodiment , a two-component MS polymer glue is used. This glue cures faster.

The term "dilatation material", as used herein, relates to a material suitable for applying between flat panels, between corner panels or between flat panels and corner panels, thus allowing these panels to shrink or expand. The dilatation material will neutralize any tensions resulting from shrinking or expanding. Examples of materials suitable for use as dilatation material include: rubber, seal kit or silicone, or joint glue.

In one embodiment of the present invention, the ceramic bricks are sequentially supported onto the substrate panels, either manually or mechanically.

At least part of the lateral sides of the substrate panel is brick-free; this part is referred to as "free space". In a preferred embodiment of the present invention, a flat panel or a corner panel must comprise at least one and preferably two such free spaces, and most preferably more than four free spaces, for example, 1, 2, 3, 4, 5, 6, 7, 8, 9, 10 or more, whereby these free spaces are located at the lateral side of the panel.

The free spaces of the adjacent panels are connecting to one another while anchoring onto the supporting structure; they are essential for this invention. At these locations the panels are anchored onto the supporting structure. Then these free spaces are manually filled up with bricks and joints. Hence, each panel is to be completed 'on-site' by adding bricks onto the adjacent free space.
A preferred embodiment of a flat panel or a corner panel according to the present invention weighs less than 25 kg and has a surface of less than 1 m². Larger panels may be up to 4 m². Panels larger than 1 m² can be placed by means of a mechanical and/or pneumatic supporting system.

This offers the advantage that such panel can be carried by an adult person. This is not only an ergonomic advantage but it also rresults into a shorter processing time. Furthermore" there is only one person required for providing the brick façade onto a supporting structure.

Upon arrival of the material, subject to the delivery sequence at the construction site, a brick facade can be provided onto a supporting structure according to the working method of this invention.

The advantage of automatic nailing is that is is rapid and that it can be carried out by a single person, which further reduces the processing time.

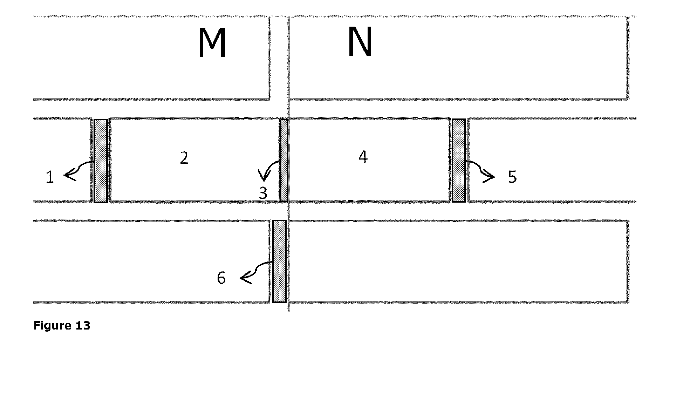

**Figure 13** shows a detailed view of contiguous free spaces for two adjacent panels M and N. The total surface of the contiguous free space is the sum of the partial surfaces **1** up to and including **5.** This does not take into account the horizontal joints between the rows of bricks. In this example, the contiguous free space is equal to the sum of the surfaces of the entire joint **1** and of a half stone strip **2,** the combined surfaces **3** and **4,** and the surface of a second full joint **5.** The combined surface **3** and **4** is equal to the half the surface of a brick strip. The surface **3** corresponds to half the surface of a joint. This is necessary because, in addition to a full brick strip, a full joint is applied around the circumference edge of panel M, for example joint **6.** The contiguous free space thus covers a surface which is larger than the entire surface of a brick strip. As a result, on panel M a free space is present, with a surface equal to the sum of the surfaces of a full joint **1** plus half a brick strip **2** plus half a joint **3.** On panel N, there is free space with a surface equal to the sum of the surface of half of a brick strip 4, less the surface of a half joint **3,** plus the surface of an entire joint **5.** The sum of the surfaces of both free spaces gives us the total surface of the contiguous free space.

The contiguous free spaces of two adjacent panels are provided with overlapping bricks or brick strips running across both panels. Preferably, the free spaces of the adjacent panels are provided with bricks after anchoring , wherein the anchoring devices are covered by by said bricks or brick strips.

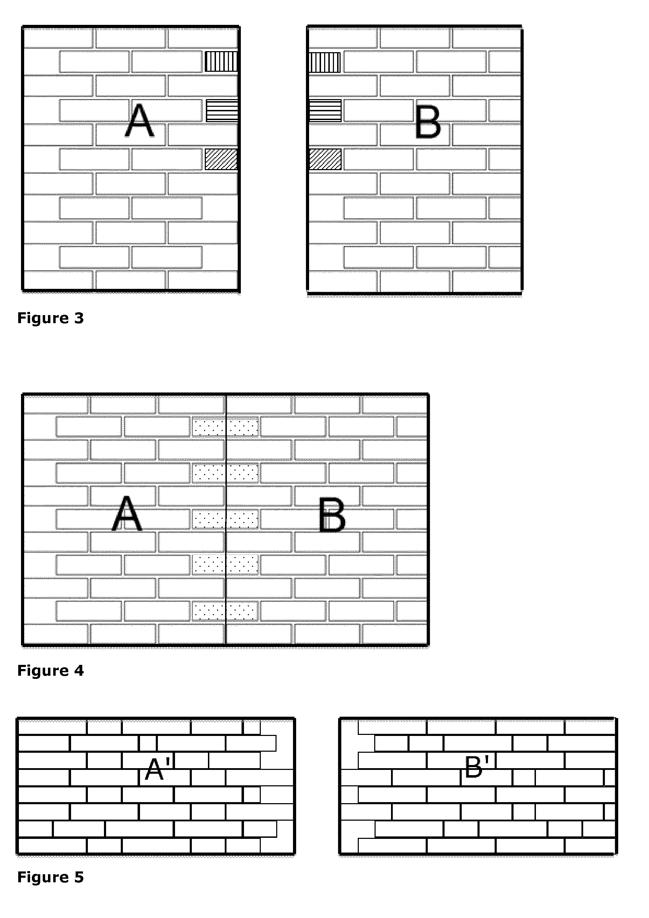

Flat panels A and B in **figures 3 and 4** were manufactured according to the embodiment as described in the present invention. Based on the building plan, a brick plan **(****figure 6****)** was drawn up. This brick plan was then subdivided into a panel plan **(****figure 7****).** Flat panels A and B are indicated on this panel plan. The panel plan shown in figure 7 comprises flat panels as well as corner panels.

Flat panels A' and B' in **Figure 5** were manufactured according to the embodiment described in the present invention. On these panels, the stones are arranged in a wild bond.

On flat panels A and B, the corresponding free spaces are shown in equal hatching in **figure 3****.** The free spaces are the spaces without bricks, thus where the substrate panel is left uncovered. **Figure 4** shows the flat panels A and B after anchoring onto the supporting structure. As a result, the contiguous free spaces are created, each of them having the surface of a full-size brick. An overlapping brick is placed onto these contiguous free spaces, as indicated by the hatching. The overlapping bricks cover the anchoring material. Both flat panels are smaller than 1m² and weigh less than 25kg. The unique identification of the panels is not rendered.

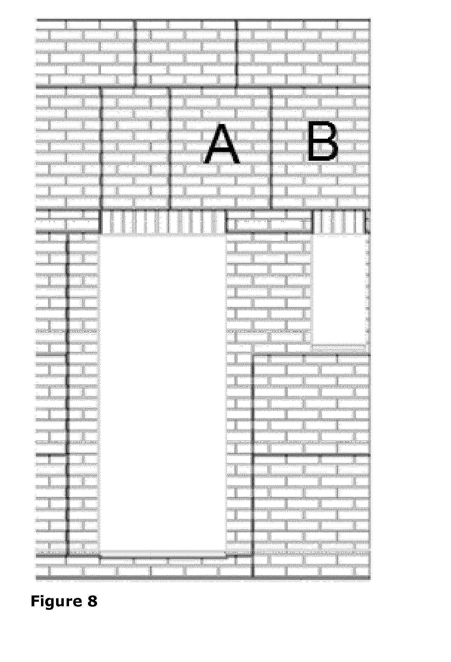

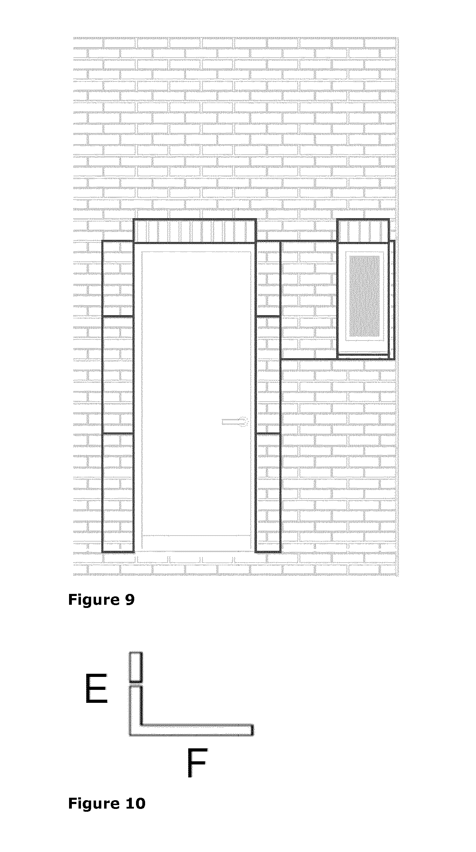

To make this clear, the plans for the flat panels and for the corner panels are shown separately in **figures 8** **and** **9****.**

A detail of the building plan for a corner joint to be constructed was enlarged in **figure 10****.** This corner joint comprises sides E and F. Side E also comprises a window.

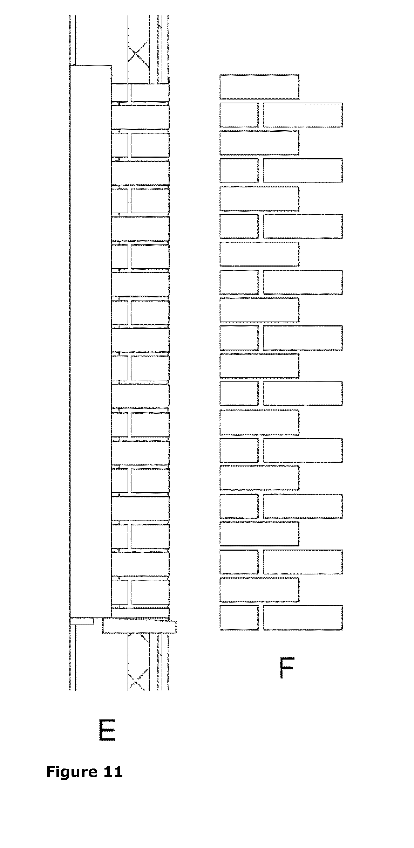

The corner panel was constructed according to the panel plan, based on the brick plan according to said building plan. The corner panel comprises two flat sides, also labelled E and F, which corresponding to the sides in the building plan. Forabsolute clarity, the two flat sides are shown in front view in **figure 11****.** The corner bricks are the same as the corner bricks on the corner panel shown in **figure 2****.**

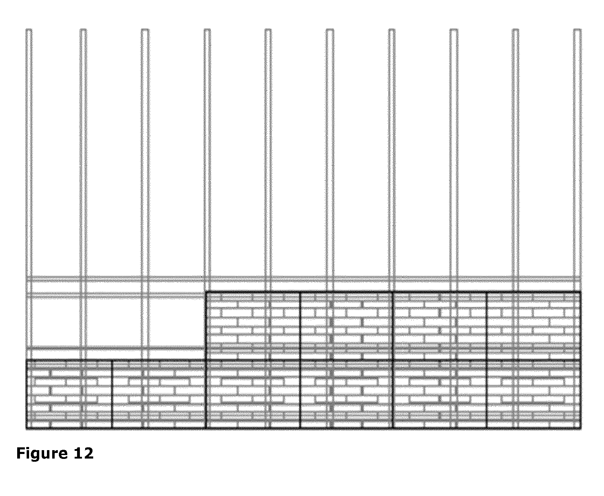

The flat panels, manufactured according to the panel plan, are provided onto the supporting structure, as shown in **figure 12****,** in order to provide a brick appearence. In this case, the supporting structure consists of a timber frame with horizontal beams mounted at equal distances. The flat panels are anchored onto the horizontal beams at the free spaces using automatic stapler guns. Afteranchoring , the overlapping bricks are placed in the contiguous free spaces. As a result, the staples are hidden from view.

**Figure 13** shows a detailed image of the contiguous free space for two flat panels M and N. This image clearly illustrates the structure of the contiguous free space.

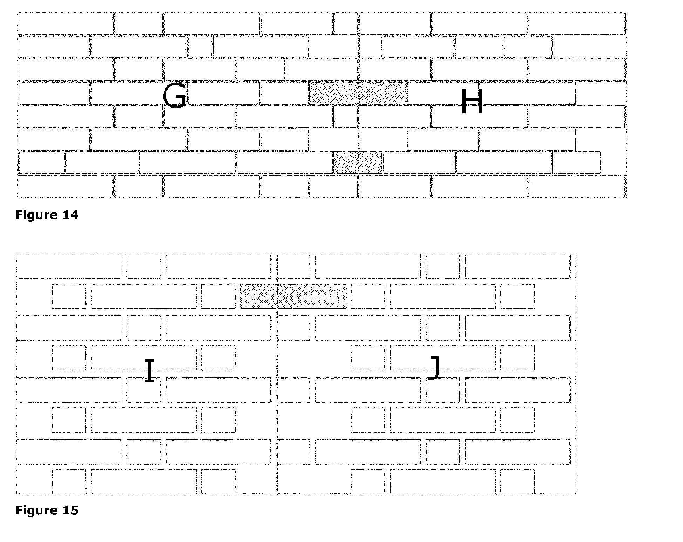

**Figure 14** shows two adjacent panels G and H after fastening onto the supporting structure and with the brick strips arranged in a wild bond. Between the brick strips, thin joints are provided with a width of 4mm. The shaded brick strips are the overlapping brick strips added after mounting of the flat panels.
The brick strips on the flat panels I and J in **figure 15** are arranged in Flemish bond. The brick strips were added using large interjacent joints. The shaded brick strip is an overlapping brick strip, added after mounting of the flat panels.

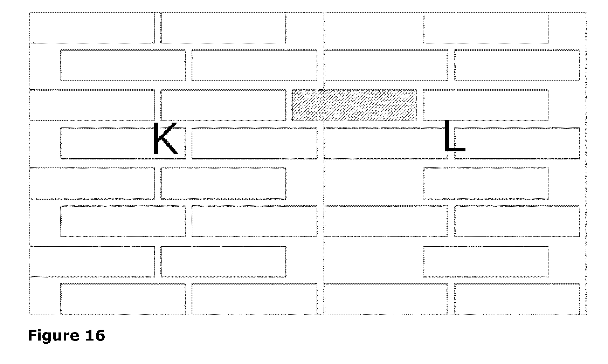

The brick strips on the flat panels K and L in **figure 16** are arranged in a quarter-brick running bond. The brick strips were added using large interjacent joints. The shaded brick strip is an overlapping brick strip, added after mounting of the flat panels.

## Claims

1. Method for providing a brick facade onto a supporting structure, for example a wall, a frame or a skeleton, comprising the following steps:
- drawing up of a brick plan, starting from a known building plan, said brick plan providing a suitable pattern of selected bricks, provided with joints;
- subdividing said brick plan into a panel plan, said panel plan comprising straight panels and corner panels, wherein said panels are restricted by an upper edge, a bottom edge and two lateral edges;
- subsequently manufacturing said panels by providing a square substrate panel with ceramic bricks , whereby these bricks are preferably fitted in a sequential manner and preferably glued to the substrate panel and subsequently provided with joints, all according to the brick plan, whereby at least part of the lateral edges of the substrate panel is left brick-free, which part is called the free space of the substrate panel;
- stacking or arranging the manufactured panels in a sequence suitable for transportation;
- transporting the panels to the supporting structure; and
- mounting said panels onto the supporting structure in a suitable order,
- providing full-size bricks onto the bridging free spaces of two adjacent panels, and
- providing a joint around said mounted bricks.

2. Method according to claim 1, whereby the panels are mounted onto the supporting structure by means of anchoring devices, such as nails, screws, staples or bolts, which extend the free spaces of the substrate panels.

3. Method according to the preceding claim 2, whereby the anchoring devices are covered by means of adding a brick.

4. Method according to one of the preceding claims 1-3, whereby a dilatation material is provided in between adjacent panels.

5. Method for the production of flat straight panels or straight corner panels suitable for the building method described in claims 1-4, comprising the following steps:
- subdividing a panel plan into flat straight substrate panels and straight corner substrate panels with a surface ranging between 0,5 and 2m² and preferably equal to about 1m²,
- providing an adhesive agent onto the substrate panels,
- gluing, preferably in a sequential manner, of ceramic bricks onto the substrate panel, and subsequently applying corresponding joints according to the brick plan; and
- drying said panels.

6. Method according to claim 5, whereby said adhesive agent is glue, preferably a silicon glue.

7. Method according to claim 5 or 6, whereby the bricks consist of ceramic bricks or ceramic brick strips.

8. Method according to claim 7, whereby the bricks consist of facade bricks made of baked clay, whereby the thickness of the bricks varies between 1to 4cm.

9. A flat square or rectangular panel manufactured according to the method described in either one of the claims 5 -8, comprising:
- a flat rectangular or flat square panel delineated by a top and bottom edge and two lateral edges, provided with full-sized bricks and joints in a suitable pattern in accordance with a brick plan;
- whereby the lateral edges comprise at least one, and preferably two free spaces, and most preferably four or more.

10. Panel according to claim 9, whereby the free space is sufficiently high for fitting a brick and sufficiently wide for fitting part of a brick.

11. Panel according to either one of the claims 9 or 10, with a surface ranging from 0.5 to 2m² and preferably about 1m² and with a weight of less than 25 kg.

12. Panel according to either one of the claims 9, 10 or 11, whereby the substrate panel is made on the basis of magnesium with a thermal resistance coefficient (according to EN 12664) of at least 1,2m m² K/W and a thermal conductivity coefficient (also according to EN 12664) of maximum 0.200 W/(mK).

13. Panel according to claim 12, whereby the magnesium mainly consists of magnesium oxide and magnesium chloride.

14. A construction kit, suitable for providing bricks onto a supporting structure, comprising:
- one or more flat panels or corner panels, provided with bricks,
- a brick plan and/or a panel plan;
- anchoring devices;
- bricks, brick strips, corner bricks or corner brick strips to be provided in the free spaces; and
- eventually a dilatation material.
